# EUROPEAN PATENT APPLICATION

(11) **EP 4 109 628 A1**
(43) Date of publication of application: **28.12.2022**
(21) Application number: 21192269.5
(22) Date of filing: 20.08.2021
(51) Int. Cl.: H01M 10/613, G06F 1/26, H01M 10/623, H01M 50/204, H01M 50/284, G06F 1/18, G06F 1/20, H01M 10/44

(54) **FANLESS PORTABLE ENERGY STORAGE POWER SUPPLY**

(30) Priority: 21.06.2021 CN 202110686876
(71) Applicant: SHENZHEN DBK ELECTRONICS CO., LTD., Guangdong (CN)
(72) Inventor: Zeng, Jinhui, Shenzhen (CN)
(74) Representative: Sun, Yiming

(57) **Abstract**

The present invention relates to the technical field of energy storage power supply and makes public a fanless portable energy storage power supply, comprising an upper shell, wherein a battery is arranged inside the upper shell; the lower part of the upper shell is fixedly connected with a lower shell; the lower inner wall of the upper shell is fixedly connected with a first fixing plate; the middle part of the first fixing plate is fixedly connected with a female insertion block; the inner wall of the female insertion block is clamped with a male insertion block; the bottom of the male insertion block is fixedly connected with a second fixing plate, the side wall of the second fixing plate is fixedly connected to the inner wall of the lower shell; the inner wall of the lower shell is fixedly connected with a circuit board, the outer side wall of the lower shell is provided with through holes; the inner wall of the lower shell is fixedly connected with a clamping strip; the inner wall of the clamping strip is clamped with a clamping groove, the inner wall of the clamping groove is clamped with a fixing frame; the inner wall of the fixing frame is fixedly connected with a filter screen; the bottom of the fixing frame is fixedly connected with a bottom plate; and the bottom plate is connected with the bottom surface of the lower shell through bolts, so as to ventilate and dissipate heat, facilitate the separation and combination of batteries and circuit boards and save resources.

## Description

### TECHNICAL FIELD

The present invention belongs to the technical field of energy storage power supply, in particular to a fanless portable energy storage power supply.

### BACKGROUND TECHNOLOGY

Mobile power supply or mobile charger is a kind of portable charger which can be carried by individuals, can store electric energy, and mainly charge consumer electronic products like hand-held mobile devices (such as radio telephones and notebook computers), especially used in occasions without external power supply. Its main components include: a battery for electric energy storage and a circuit for stabilizing output voltage (DC-DC converter), and most mobile power supplies have chargers for charging as built-in batteries.

When the existing energy storage power supply is running, the internal heat of the power supply is too high due to the heat dissipation of internal electronic components, which affects the service life of the energy storage power supply. In addition, the existing storage power supply generally dissipates heat through a fan, which has high noise and limited service life. In order to solve the above problems, a portable fanless portable energy storage power supply is proposed.

### SUMMARY OF THE INVENTION

The present invention aims at providing a fanless portable energy storage power supply in order to solve the above problems.

The technical scheme adopted by the present invention is as follows: A fanless portable energy storage power supply, comprises an upper shell, wherein a battery is arranged inside the upper shell; the lower part of the upper shell is fixedly connected with a lower shell; the inner wall of the lower part of the upper shell is fixedly connected with a first fixing plate; the middle part of the first fixing plate is fixedly connected with a female insertion block; the inner wall of the female insertion block is clamped with a male insertion block; the bottom of the male insertion block is fixedly connected with a second fixing plate; the side wall of the second fixing plate is fixedly connected to the inner wall of the lower shell; the inner wall of the lower shell is fixedly connected with a circuit board; the outer side wall of the lower shell is provided with through holes; the inner wall of the lower shell is fixedly connected with a clamping strip; the inner wall of the clamping strip is clamped with a clamping groove; the inner wall of the clamping groove is clamped with a fixing frame; the inner wall of the fixing frame is fixedly connected with a filter screen; the bottom of the fixing frame is fixedly connected with a bottom plate; and the bottom plate is connected with the bottom surface of the lower shell through bolts.

In a preferred embodiment, the female insertion block and the male insertion block are internally provided with metal connecting contact points, the female insertion block is connected with the battery through wires, and the male insertion block is connected with the circuit board through copper wires.

In a preferred embodiment, the number of the through holes is not set single, and the through holes are arranged on the left and right side walls of the lower shell at equal intervals in turn.

In a preferred embodiment, the number of the clamping strips and the clamping grooves is four, and each two are arranged symmetrically on the two inner side walls of the lower shell in a group.

In a preferred embodiment, the number of the top strips and the bottom plates is two, each top strip and each bottom plate are respectively arranged at the top end and the bottom end of each group of the clamping strips, the interval between the bottom surfaces of the inner walls of the two symmetrical clamping grooves in each group is adapted to the width of the fixing frame, and the width of the inner wall of the clamping groove is adapted to the width of the fixing frame.

To sum up, through the technical scheme mentioned above, the present invention has the beneficial effects:
1. In the present invention, through the through holes on both side walls of the lower shell, air is inlet through the through holes on one side and outlet through the through holes on the other side to form a through-ventilation structure, which is convenient to quickly ventilate and dissipate heat on the circuit board on the lower shell. The structure has good ventilation effect and no fan noise, and can effectively reduce heat dissipation cost. In addition, the through holes on both sides are provided with filter screens clamped on the clamping grooves of the clamping strips to prevent dust from entering the shell. By disassembling the bolts connecting the bottom plate and the lower shell, and then pulling the filter screen outward, the filter screen can be quickly disassembled by sliding the filter screen in the fixing frame in the clamping groove, which is convenient for cleaning the filter screen and avoids blockage, and is very practical.
2. In the present invention, the battery is connected with the male insertion block on the second fixed plate through the female insertion block on the first fixed plate, so that the circuit board is connected with the battery. When the upper and lower shells are separated through the connection, the battery and the circuit board can be separated quickly. When there is damage between the upper and lower shells, the intact upper and lower shell parts can be matched and spliced with other good upper and lower shell parts, so as to recycle and save resources.

### DESCRIPTION OF DRAWINGS

Fig. 1 is a schematic diagram of the three-dimensional structure of the present invention;
Fig. 2 is a schematic plan view of the front view of internal structure of the present invention;
Fig. 3 is an enlarged view of A in Fig. 2 of the present invention;
Fig. 4 is an enlarged view of B in Fig. 2 of the present invention;
Fig. 5 is a schematic diagram of the three-dimensional structure of the clamping strip of the present invention;
Fig. 6 is a schematic diagram of the three-dimensional structure of the filter screen of the present invention.

Mark in the figure: 1-upper shell, 2-battery, 3-lower shell, 4-first fixing plate, 5-female insertion block, 6-male insertion block, 7-second fixing plate, 8-circuit board, 9-through hole, 10-clamping strip, 11-top strip, 12-clamping groove, 13-fixing frame, 14-filter screen and 15-bottom plate.

### SPECIFIC EMBODIMENTS

In order to make the objects, technical schemes and advantages of the embodiments of the present invention clearer, the technical schemes of the embodiments of the present invention will be clearly and completely described below in connection with the embodiments of the present invention, and it is obvious that the described embodiments are part of, but not all of, the embodiments of the present invention. Based on the embodiments of the present invention, all other embodiments obtained by common technical personnel in the field without performing creative labor belong to the scope of the protection of the present invention.

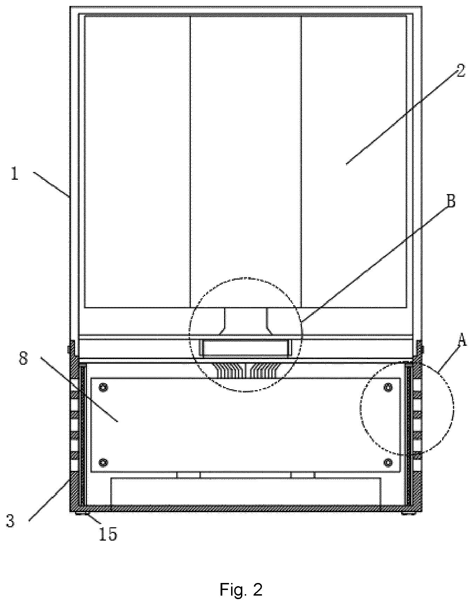

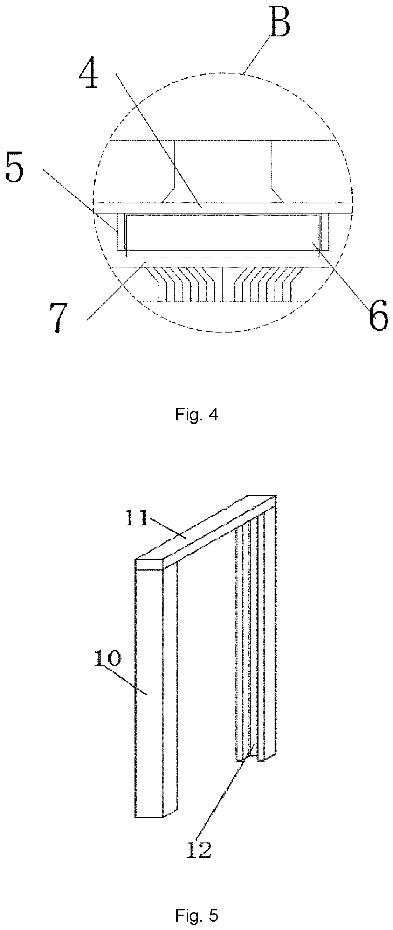

Referring to Fig. 2 and 4, the embodiment of the present invention provides a distillation device for producing perfume, comprising an upper shell 1, wherein a battery 2 is arranged inside the upper shell 1; the lower part of the upper shell 1 is fixedly connected with a lower shell 3; the upper shell 1 is made of plastic; the lower shell 2 is made of metal; the lower inner wall of the upper shell 1 is fixedly connected with a first fixing plate 4; the middle part of the first fixing plate 4 is fixedly connected with a female insertion block 5; the inner wall of the female insertion block 5 is clamped with a male insertion block 6; the bottom of the male insertion block 6 is fixedly connected with a second fixing plate 7; the side wall of the second fixing plate 7 is fixedly connected with the inner wall of the lower shell 3.

As an example, by separating the upper and lower shells, the female insertion block 5 on the first fixing plate 4 and the male insertion block 6 on the second fixing plate 7 are separated at this time, so that the battery 2 and the circuit board 8 can be separated quickly, and the intact upper and lower shell parts can be matched and spliced with other good upper and lower shell parts, so as to recycle and save resources.

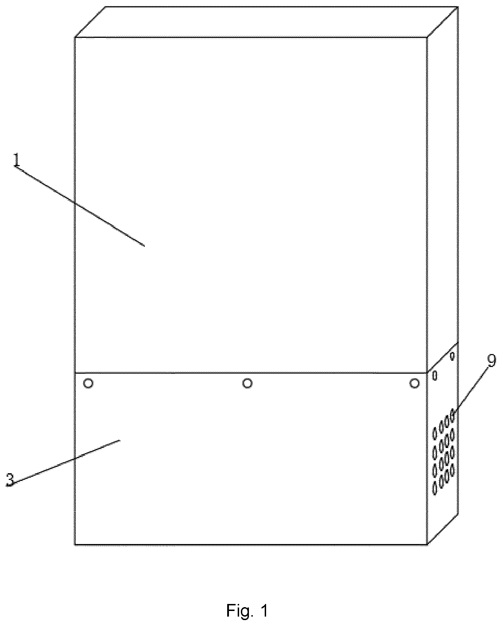

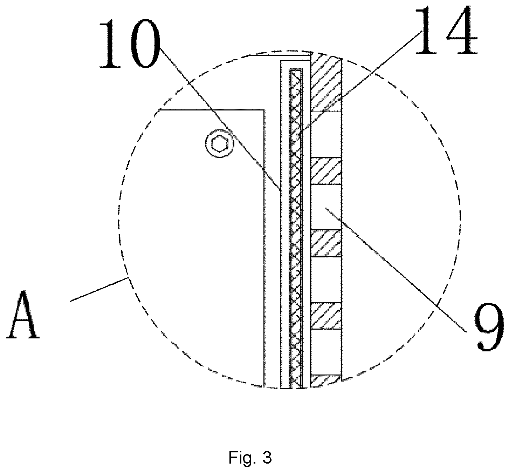

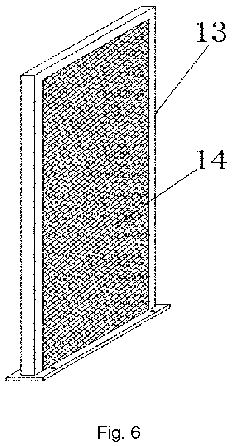

Referring to Fig. 1, Fig. 2, Fig. 3, Fig. 5 and Fig. 6, the inner wall of the lower shell 3 is fixedly connected with a circuit board 8; the outer side wall of the lower shell 3 is provided with through holes 9; the inner wall of the lower shell 3 is fixedly connected with a clamping strip 10; the top of the clamping strip 10 is fixedly connected with a top strip 11; the inner wall of the clamping strip 10 is clamped with a clamping groove 12; the inner wall of the clamping groove 12 is clamped with a fixing frame 13; the inner wall of the fixing frame 13 is fixedly connected with a filter screen 14; the bottom of the fixing frame 13 is fixedly connected with a bottom plate 15; and the bottom plate 15 is connected to the bottom surface of the lower shell 3 through bolts.

As an example, the through-ventilation structure can effectively dissipate the heat generated on the circuit board 8. A filter screen 14 is arranged at the rear of the through holes 9 to prevent dust from entering the shell, and the filter screen 14 can be disassembled to facilitate cleaning and prevent the filter screen 14 from being blocked.

Referring to Fig. 4, the female insertion block 5 and the male insertion block 6 are internally provided with metal connecting contact points; the female insertion block 5 is connected with the battery 2 through wires; and the male insertion block 6 is connected with the circuit board 8 through copper wires.

As an example, the use of male and female insertion blocks enables the battery 2 and the circuit board 8 to be quickly connected and conveniently disconnected.

Referring to Fig. 1 and Fig. 2, the number of the through holes 9 is not set single, and the through holes 9 are arranged on the left and right side walls of the lower shell 3 at equal intervals in turn.

As an example, through the through holes 9 of the side walls on both sides, air is inlet through the through holes 9 on one side and outlet through the through holes 9 on the other side to form a through-ventilation structure, which is convenient to quickly ventilate and dissipate heat on the circuit board 8 on the lower shell 3.

Referring to Fig. 2, Fig. 3, Fig. 5, and Fig. 6, the number of the clamping strips 10 and the clamping grooves 12 is four, and each two are arranged symmetrically on the two inner side walls of the lower shell 3 in a group.

As an example, the clamping groove 12 restricts the upper, lower, left and right positions of the fixing frame 13 and facilitates the disassembly of the filter screen 14.

Referring to Fig. 2, Fig. 3, Fig. 5, and Fig. 6, the number of the top strips 11 and the bottom plates 15 is two; each top strip 11 and each bottom plate 15 are respectively arranged at the top end and the bottom end of each group of the clamping strips 10; the interval between the bottom surfaces of the inner walls of the two symmetrical clamping grooves 12 in each group is adapted to the width of the fixing frame 13; and the width of the inner wall of the clamping groove 12 is adapted to the width of the fixing frame 13.

As an example, by removing the bolts connecting the bottom plate 15 and the lower shell 3 and then pulling the filter screen 14 outward, the filter screen 14 slides in the clamping groove 12 through the fixing frame 13, so that the filter screen 14 can be quickly removed Working principle: During the use of the fanless portable energy storage power supply, through the through holes 9 on both side walls of the lower shell 3, air is inlet through the through holes 9 on one side and outlet through the through holes 9 on the other side to form a through-ventilation structure, which is convenient to quickly ventilate and dissipate heat on the circuit board 8 on the lower shell 3. In addition, the through holes 9 on both sides are provided with filter screens 14 clamped on the clamping grooves 12 of the clamping strips 10 to prevent dust from entering the shell. By disassembling the bolts connecting the bottom plate 15 and the lower shell 3, and then pulling the filter screen 14 outward, the filter screen 14 can be quickly disassembled by sliding the filter screen 14 in the fixing frame 13 in the clamping groove 12, which is convenient for cleaning the filter screen 14. When the upper or lower shell is damaged, by separating the upper and lower shells, the female insertion block 5 on the first fixing plate 4 and the male insertion block 6 on the second fixing plate 7 are separated at this time, so that the battery 2 and the circuit board 8 can be separated quickly, and the intact upper and lower shell parts can be matched and spliced with other good upper and lower shell parts, so as to recycle and save resources.

It needs to be noted that relational terms such as first and second are used herein only to distinguish one entity or operation from another and do not necessarily require or imply any such actual relationship or order between these entities or operations. Moreover, the terms "comprise", "include" or any other variation thereof are intended to encompass non-exclusive inclusion, so that such process, method, article or equipment that includes a set of elements includes not only those elements but also other elements that are not explicitly listed or are inherent to such process, method, article or equipment. In the absence of further limitations, an element defined by the phrase "comprise a/an ..." does not preclude the existence of other identical elements in the process, method, article or equipment in which the element is included.

The above embodiments are only used to illustrate the technical scheme of the present invention, but not to limit it. Although the present invention has been described in detail with reference to the foregoing embodiments, it should be understood by those common technical personnel that the technical scheme described in the foregoing embodiments can still be modified or some technical features thereof can be equivalently substituted and these modifications or substitutions do not depart the essence of the corresponding technical scheme from the spirit and scope of the technical scheme of the embodiments of the present invention.

## Claims

1. A fanless portable energy storage power supply, comprises an upper shell (1), wherein a battery (2) is arranged inside the upper shell (1); the lower part of the upper shell (1) is fixedly connected with a lower shell (3); the inner wall of the lower part of the upper shell (1) is fixedly connected with a first fixing plate (4); the middle part of the first fixing plate (4) is fixedly connected with a female insertion block (5); the inner wall of the female insertion block (5) is clamped with a male insertion block (6); the bottom of the male insertion block (6) is fixedly connected with a second fixing plate (7); the side wall of the second fixing plate (7) is fixedly connected to the inner wall of the lower shell (3); the inner wall of the lower shell (3) is fixedly connected with a circuit board (8); the outer side wall of the lower shell (3) is provided with through holes (9); the inner side wall of the lower shell (3) is fixedly connected with a clamping strip (10); the top of the clamping strip (10) is fixedly connected with a top strip (11); the inner wall of the clamping strip (10) is clamped with a clamping groove (12); the inner wall of the clamping groove (12) is clamped with a fixing frame (13); the inner wall of the fixing frame (13) is fixedly connected with a filter screen (14); the bottom of the fixing frame (13) is fixedly connected with a bottom plate (15); and the bottom plate (15) is connected with the bottom surface of the lower shell (3) through bolts.

2. The fanless portable energy storage power supply according to claim 1, wherein the female insertion block (5) and the male insertion block (6) are internally provided with metal connecting contact points; the female insertion block (5) is connected with the battery (2) through wires; and the male insertion block (6) is connected with the circuit board (8) through copper wires.

3. The fanless portable energy storage power supply according to claim 1, wherein the number of the through holes (9) is not set single, and the through holes (9) are arranged on the left and right side walls of the lower shell (3) at equal intervals in turn.

4. The fanless portable energy storage power supply according to claim 1, wherein the number of the clamping strips (10) and the clamping grooves (12) is four, and each two are arranged symmetrically on the two inner side walls of the lower shell (3) in a group.

5. The fanless portable energy storage power supply according to claim 1, wherein the number of the top strips (11) and the bottom plates (15) is two, each top strip (11) and each bottom plate (15) are respectively arranged at the top end and the bottom end of each group of the clamping strips (10), the interval between the bottom surfaces of the inner walls of the two symmetrical clamping grooves (12) in each group is adapted to the width of the fixing frame (13), and the width of the inner wall of the clamping groove (12) is adapted to the width of the fixing frame (13).
